# EUROPEAN PATENT SPECIFICATION

(11) **EP 4 106 124 B1**
(45) Date of publication and mention of the grant of the patent: **21.10.2026**
(21) Application number: 22175679.4
(22) Date of filing: 26.05.2022
(51) Int. Cl.: H02H 3/08, H02H 7/12, H02H 1/06

(54) **TERMINAL PROTECTION VOLTAGE CIRCUIT AND POWER SUPPLY APPARATUS**
KLEMMENSCHUTZSPANNUNGSKREIS UND STROMVERSORGUNGSGERÄT
CIRCUIT DE TENSION DE PROTECTION DE TERMINAL ET APPAREIL D'ALIMENTATION ÉLECTRIQUE

(30) Priority: 16.06.2021 JP 2021100187
(43) Date of publication of application: 21.12.2022
(73) Proprietor: OMRON Corporation, Kyoto-shi, Kyoto 600-8530 (JP)
(72) Inventor: NAGANO, Masaaki, Kyoto, 600-8530 (JP); WATANABE, Tomonori, Kyoto, 600-8530 (JP); TANINO, Kohei, Kyoto, 600-8530 (JP)
(74) Representative: HGF

(56) References cited:
- EP-A2- 2 388 598
- CN-A- 112 865 498
- JP-A- 2016 116 366
- US-A1- 2017 317 488
- US-A1- 2022 247 317

## Description

### BACKGROUND OF THE INVENTION

### FIELD OF THE INVENTION

d The present disclosure relates to a terminal protection voltage detector circuit for protecting a plurality of terminals of a power supply apparatus, and a power supply apparatus including the terminal protection voltage detector circuit.

### DESCRIPTION OF RELATED ART

A power supply apparatus according to the prior art includes a terminal block having a plurality of output terminals for connecting a plurality of loads (see, for example, Patent Document 1). In this case, in general, for example, in the case of a power supply apparatus capable of outputting a large current, it is necessary to increase the size of a terminal block having a plurality of output terminals according to the output current. US 2022/247317 A1 discloses a controller for a multiphase switching converter comprising a voltage control circuit, a total current control circuit, a frequency divider and a plurality of sub control circuits. US 2017/317488 A1 discloses an over-current protection circuit comprising a signal generating block, a control block, an analog control loop block and a phase control logic block.

### PRIOR ART DOCUMENT:

### PATENT DOCUMENT:

Patent Document 1: Japanese Patent Laid-open Publication No. JP2016-116366A.

However, when the actual terminal block in the power supply apparatus is increased in size, the wiring becomes thick, and processing becomes difficult. In addition, even if the wiring is divided into each of loads in order to divide the output current, if the load is short-circuited and destroyed, the output current concentrates thereon, and there is a possibility that the wiring of the corresponding output terminal is burned out.

In addition, even in a case where the user intends to connect two wirings in parallel, but one wiring is not in contact due to erroneous connection, and the output current is concentrated on one wiring, there is a possibility that the wiring is burned out.

Further prior art power supply circuits are known from US 2022/0247317 A1, which discloses a multiphase switching converter controlling total current through a plurality of switching circuits, and from US 2017/0317488 A1, which discloses an over-current protection circuit using average voltage comparison across inductor phases.

### SUMMARY OF THE DISCLOSURE

An object of the present disclosure is to solve the above problems, and to provide a terminal protection voltage detector circuit capable of detecting the current of each of the output terminals and eliminating the burnout risk as described above, and a power supply apparatus including the terminal protection voltage detector circuit.

According to one aspect of the present disclosure, there is provided in claim 1 a terminal protection voltage detector circuit for protecting a terminal block having a plurality of output terminals in a power supply apparatus. The terminal protection voltage detector circuit includes a current detector, first and second comparators, and a current stop circuit. The current detector detect a plurality of output currents flowing from the power supply apparatus to a plurality of loads via a plurality of output terminals, and the first comparator configured to compare a sum of the plurality of detected output currents with a predetermined first threshold, and output a first comparison result signal when the sum of the plurality of output currents is larger than or equal to the first threshold. The second comparator configured to compare a maximum value of the plurality of detected output currents with a predetermined second threshold, and output a second comparison result signal when the maximum value is equal to or larger than the second threshold. The current stop circuit stops a current from flowing from the power supply apparatus to the plurality of output terminals based on the first comparison result signal or the second comparison result signal.

Therefore, according to the terminal protection voltage detector circuit of the present disclosure, it is possible to detect the current of each of the output terminals and eliminate the above-described burnout risk.

According to another aspect of the present disclosure, there is provided a power supply apparatus according to claim 5

### BRIEF DESCRIPTION OF THE DRAWING

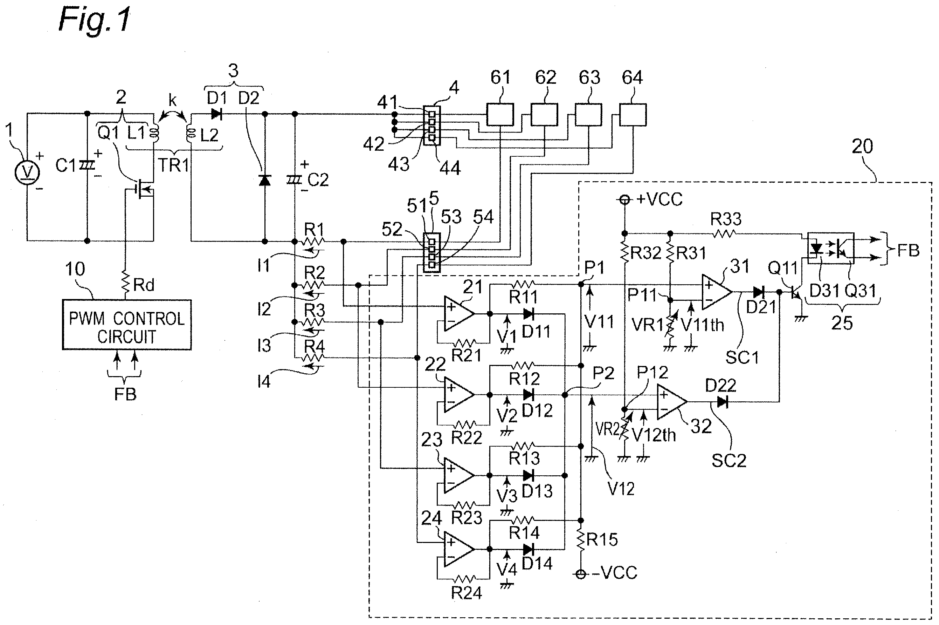

Fig. 1 is a block diagram illustrating a configuration example of a power supply apparatus including a terminal protection voltage detector circuit 20 according to an embodiment.

### MODE FOR CARRYING OUT THE DISCLOSURES

Hereinafter, embodiments according to the present disclosure will be described with reference to the drawing. The same or similar components are denoted by the same reference numerals.

### FINDINGS OF THE INVENTOR

As described above, in the power supply apparatus according to the prior art including the terminal block having the plurality of output terminals in order to connect the plurality of loads, for example, in the case of a power supply apparatus capable of outputting a large current, it is necessary to increase the size of the terminal block having the plurality of output terminals according to the output current. However, when the actual terminal block in the power supply apparatus is increased in size, the wiring becomes thick, and processing becomes difficult. In addition, even if the wiring is divided into each of the loads in order to divide the output current, if the load is short-circuited and destroyed, the output current concentrates thereon, and there is a possibility that the wiring of the corresponding output terminal is burned out. Therefore, it is necessary to prevent such a situation.

Therefore, the present inventor has devised a configuration in which overcurrent monitoring is performed in each of output terminals so that each of the output terminals does not exceed the rating. Specifically, after the output current of each of the output terminals is amplified by each of the differential amplifiers, the current control for protecting each of terminals and the current control of the total sum of the currents are simultaneously performed, so that the current control of each of the output terminals can be performed without greatly affecting the mounting area.

### EMBODIMENTS

Fig. 1 is a block diagram illustrating a configuration example of a power supply apparatus including a terminal protection voltage detector circuit 20 according to an embodiment.

Referring to Fig. 1, the power supply apparatus according to the embodiment is configured to include a DC power supply 1, a smoothing electrolytic capacitor C1, an inverter circuit 2, a rectifier circuit 3, a smoothing electrolytic capacitor C2, a resistor Rd, a PWM control circuit 10, a terminal block 4 having four output terminals 41 to 44, a terminal block 5 having four output terminals 51 to 54, current detection resistors R1 to R4, and a terminal protection voltage detector circuit 20. The inverter circuit 2 includes a MOS transistor Q1 and an inductor L1, and the rectifier circuit 3 includes two diodes D1 and D2 and configures a single-phase full-wave rectifier circuit. In this case, the inductors L1 and L2 configure a transformer TR1 electromagnetically coupled with a coupling degree k.

The PWM control circuit 10 is a drive control circuit of the inverter circuit 2, generates a PWM gate signal (drive control signal) having a predetermined period based on a feedback control signal FB from the terminal protection voltage detector circuit 20, and applies the PWM gate signal to the gate of the MOS transistor Q1 via the resistor Rd. As a result, the inverter circuit 2 generates an AC voltage by switching a DC voltage from the DC power supply 1 and outputs the AC voltage to the rectifier circuit 3. The PWM control circuit 10 generates a PWM gate signal based on the low-level feedback control signal FB and stops the generation thereof based on the high-level feedback control signal FB. The rectifier circuit 3 converts the input AC voltage into a DC voltage, and outputs the DC voltage to loads 61 to 64 via the current detection resistors R1 to R4 (only the negative side) and the output terminals (41, 51; 42, 52; 43, 53; 44, and 54) of the terminal blocks 4 and 5.

The terminal protection voltage detector circuit 20 is configured to include:
(1) a differential amplifier 21 having a feedback resistor R21, an output resistor R11, and an output diode D11;
(2) a differential amplifier 22 having a feedback resistor R22, an output resistor R12, and an output diode D12;
(3) a differential amplifier 23 having a feedback resistor R23, an output resistor R13, and an output diode D13;
(4) a differential amplifier 24 having a feedback resistor R24, an output resistor R14, and an output diode D14;
(5) a resistor R15;
(6) voltage-dividing resistors R31 and R32;
(7) variable resistors VR1 and VR2;
(8) an output resistor R33;
(9) comparators 31 and 32;
(10) output diodes D21, D22;
(11) a bipolar transistor Q11; and
(12) a photocoupler 25 having a light emitting diode D31 and a phototransistor Q31.

Each of the differential amplifiers 21 to 24 is a so-called operational amplifier, and is configured to amplify and output a voltage having a difference obtained by subtracting a voltage applied to an inverting input terminal from a voltage applied to a non-inverting input terminal.

A voltage between both ends of the current detection resistor R11 (the voltage between both ends is proportional to an output current I1 flowing through the output terminal 51 or the load 61) is applied to the inverting input terminal of the differential amplifier 21, and the feedback resistor R21 is connected between the inverting input terminal and the output terminal. An output voltage V1 of the differential amplifier 21 is outputted to a non-inverting input terminal of the comparator 31 via the resistor R11 and a connection point P1, and is outputted to a non-inverting input terminal of the comparator 32 via the output diode D11 and a connection point P2.

A voltage between both ends of the current detection resistor R12 (the voltage between both ends is proportional to an output current I2 flowing through the output terminal 52 or the load 62) is applied to the non-inverting input terminal of the differential amplifier 22, and the feedback resistor R22 is connected between the inverting input terminal and the output terminal. An output voltage V2 of the differential amplifier 22 is outputted to the non-inverting input terminal of the comparator 31 via the resistor R12 and the connection point P1, and is outputted to the non-inverting input terminal of the comparator 32 via the output diode D12 and the connection point P2.

A voltage between both ends of the current detection resistor R13 (the voltage between both ends is proportional to an output current I3 flowing through the output terminal 53 or the load 63) is applied to the non-inverting input terminal of the differential amplifier 23, and the feedback resistor R23 is connected between the inverting input terminal and the output terminal. An output voltage V3 of the differential amplifier 23 is outputted to the non-inverting input terminal of the comparator 31 via the resistor R13 and the connection point P1, and is outputted to the non-inverting input terminal of the comparator 32 via the output diode D13 and the connection point P2.

A voltage between both ends of the current detection resistor R14 (the voltage between both ends is proportional to an output current I4 flowing through the output terminal 54 or the load 64) is applied to the non-inverting input terminal of the differential amplifier 24, and the feedback resistor R24 is connected between the inverting input terminal and the output terminal. An output voltage V4 of the differential amplifier 24 is outputted to the non-inverting input terminal of the comparator 31 via the resistor R14 and the connection point P1, and is outputted to the non-inverting input terminal of the comparator 32 via the output diode D14 and the connection point P2.

In this case, the connection point P1 is connected to a negative power supply voltage -VCC via the resistor R15. A positive power supply voltage + VCC is grounded via the voltage-dividing resistor R31 and the variable resistor VR1, and is grounded via the voltage-dividing resistor R32 and the variable resistor VR2. In addition, the positive power supply voltage + VCC is connected to an anode of the light emitting diode D31 of the photocoupler 25 via the resistor R33, and a cathode thereof is grounded via a collector and an emitter of the bipolar transistor Q11.

A voltage V11th at a connection point P11 between the voltage-dividing resistor R31 and the variable resistor VR1 is set by adjusting the variable resistor VR1 so as to correspond to, for example, the rated current of the total current of the output terminals 51 to 54, and the voltage is applied to an inverting input terminal of the comparator 31 as a first threshold voltage V11. In addition, a voltage V12th at a connection point P12 between the voltage-dividing resistor R32 and the variable resistor VR2 is set by adjusting the variable resistor VR2 so as to correspond to, for example, the rated current of each of the current flowing through the output terminals 51 to 54, and the voltage is applied to an inverting input terminal of the comparator 32 as a second threshold voltage V12.

In this case, the voltage V11 at the connection point P1 corresponds to be proportional to the sum (total current) of the currents flowing through the output terminals 51 to 54. In addition, the voltage V12 at the connection point P2 corresponds to be proportional to the maximum value of each of the currents flowing through the output terminals 51 to 54.

The comparator 31 applies a high-level comparison result signal SC1 to the base of the bipolar transistor Q11 via the diode D21 when V11 ≥ V11th, and applies a low-level comparison result signal SC1 to the base of the bipolar transistor Q11 via the diode D21 when V11 < V11th. In addition, the comparator 32 applies a high-level comparison result signal SC2 to the base of the bipolar transistor Q11 via the diode D22 when V12 ≥ V12th, and applies a low-level comparison result signal SC2 to the base of the bipolar transistor Q11 via the diode D22 when V12 < V12th.

In this case, the current detection resistors R1 to R4 (which may further include the differential amplifiers 21 to 24) are examples of a current detector, and the comparators 31 and 32 are examples of a comparator.

When any one of the comparison result signals SC1 and SC2 has the high level, the bipolar transistor Q11 is turned on, and as a result, the light emitting diode D31 emits light, the emitted light enters the phototransistor Q31, and the high-level feedback control signal FB is outputted to the PWM control circuit 10. On the other hand, when both of the comparison result signals SC1 and SC2 have the low level, the bipolar transistor Q11 is turned off, and as a result, the light emitting diode D31 is turned off, and the low-level feedback control signal FB is output from the photocoupler 25 to the PWM control circuit 10.

The operation of the power supply apparatus including the terminal protection voltage detector circuit 20 configured as described above will be described below.

The output currents I1 to I4 of the power supply apparatus return from the output terminals 41 to 44 of the positive-side terminal block 4 to the output terminals 51 to 54 of the negative-side terminal block 5 via the loads 61 to 64, respectively. In this case, the current I1 flowing through the output terminal 51 flows to the resistor R1, and the voltage between both ends of the resistor R1 is amplified by the differential amplifier 21 and then becomes the voltage V1. In addition, the current I2 flowing through the output terminal 52 flows to the resistor R2, and the voltage between both ends of the resistor R2 is amplified by the differential amplifier 22 and then becomes the voltage V2. Further, the current I3 flowing through the output terminal 53 flows to the resistor R3, and the voltage between both ends of the resistor R3 is amplified by the differential amplifier 23 and then becomes the voltage V3. Furthermore, the current I4 flowing through the output terminal 54 flows to the resistor R4, and the voltage between both ends of the resistor R4 is amplified by the differential amplifier 24 and then becomes the voltage V4.

In this case, since the output terminals 41 to 44, 51, and 54 of the terminal blocks 4 and 5 generally have the same shape, for example, the following equations are set:

R1=R2=R3=R4
R11=R12=R13=R14

(CASE 1) When a current larger than or equal to the rated current (corresponding to the second threshold voltage V12th) flows through any one of the output terminals 41 to 44 (when the maximum value of each of the currents flowing through the output terminals 41 to 44 becomes larger than or equal to the rated current),
(1) V1 ≥ V12th;
(2) V2 ≥ V12th;
(3) V3 ≥ V12th; or
(4) V4 ≥ V12th, and
the comparison result signal SC2 becomes the high level. At this time, the photodiode D31 of the photocoupler 25 is turned on to generate the high-level feedback control signal FB, and the generation of the PWM gate signal by the PWM control circuit 10 is stopped.

(CASE 2) When the output current of the entire power supply apparatus exceeds the rated current (corresponding to the first threshold voltage V11th),
(1) a current flowing through the output resistor R11 is V1/R11;
(2) a current flowing through the output resistor R12 is V1/R12;
(3) a current flowing through the output resistor R13 is V1/R13; and
(4) a current flowing through the output resistor R14 is V1/R14, and
since the combined current becomes larger than the current value of - VCC/R15 flowing from the negative power supply voltage -VCC, then the comparison result signal SC1 becomes the high level. At this time, the photodiode D31 of the photocoupler 25 is turned on to generate the high-level feedback control signal FB, and the generation of the PWM gate signal by the PWM control circuit 10 is stopped.

In the above case 1 or 2, when the current of the entire power supply apparatus exceeds the rated current amount (first threshold current) or when any one of the currents of the output terminals exceeds the rated current (second threshold current), the high-level feedback control signal FB is generated, and the generation of the PWM gate signal by the PWM control circuit 10 is stopped. As a result, it is possible to prevent the output terminals 41 to 44 and 51 to 54 of the terminal blocks 4 and 5 or the wirings thereof from being destroyed by burnout and to prevent an overcurrent from flowing through the power supply apparatus.

As described above, according to the embodiment, in a case where wiring is performed from a plurality of output terminals in order to cause a large current to flow, it is possible to prevent load damage and current concentration on the output terminals at the time of non-contact of the terminals, and it is possible to eliminate the risk of burnout of the output terminals and the wirings.

### MODIFIED EMBODIMENTS

In the above embodiment, the PWM control circuit 10 generates the PWM gate signal based on the feedback control signal FB to drive and control the inverter circuit 2. However, the present disclosure is not limited to this, and the inverter circuit 2 may be driven and controlled by a drive control circuit such as an FM control circuit using another method such as a method of controlling by frequency using an FM gate signal.

In the above embodiment, the terminal blocks 4 and 5 each having the four output terminals 41 to 44 and 51 to 54 are provided, but the present disclosure is not limited thereto, and a plurality of terminal blocks may be used.

In the above embodiment, the current detection resistors R1 to R4 are inserted on the negative sides of the output terminals, but the present disclosure is not limited thereto, and may be inserted on the positive sides of the output terminals.

In the above embodiment, the inverter circuit 2 is configured by a circuit that converts a DC voltage into an AC voltage, but the present disclosure is not limited thereto, and may be configured by a circuit that converts DC power into AC power.

In the above embodiment, the rectifier circuit 3 is configured by a circuit that converts an AC voltage into a DC voltage, but the present disclosure is not limited thereto, and may be configured by a circuit that converts AC power into DC power.

In the above embodiment, the inverter circuit 2 is configured using the MOS transistor Q1 as a switching element, but the present disclosure is not limited thereto, and may be configured using a switching element such as a thyristor.

### DESCRIPTION OF NUMERICAL REFERENCES

1: DC power supply
2: Inverter Circuit
3: Rectifier circuit
4 and 5: Terminal block
10: PWM control circuit
20: Terminal protection voltage detector circuit
21 to 24: Differential amplifier
25: Photocoupler
31 and 32: Comparator
41 to 44 and 51 to 54: Output terminal
61 to 64: Load
C1 to C2: Electrolytic capacitor
D1 to D22: Diodes
D31: Light emitting diode
L1 and L2: Inductor
P1 to P12: Junction point
Q1: MOS transistor
Q11: Bipolar transistor
Q31: Phototransistor
Rd and R11 to R33: Resistor
R1 to R4: Current detection resistor
TR1: Transformer
VR1 and VR2: Variable resistor

## Claims

1. A terminal protection voltage detector circuit (20) comprising:
a current detector (R1-R4; 21-24) configured to detect a plurality of output currents flowing from a power supply apparatus to a plurality of loads (61-64) via a plurality of output terminals (41-44); and
a first comparator (31) configured to compare a sum of the plurality of detected output currents with a predetermined first threshold, and output a first comparison result signal when the sum of the plurality of output currents is larger than or equal to the first threshold;
**characterized in that**
the terminal protection voltage detector circuit is provided for protecting a terminal block (4) having the plurality of output terminals (41-44) in a power supply apparatus,
wherein the voltage detector circuit (20) further comprises
a second comparator (32) configured to compare a maximum value of the plurality of detected output currents with a predetermined second threshold, and output a second comparison result signal when the maximum value is equal to or larger than the second threshold; and
a current stop circuit (Q11) configured to stop a current from flowing from the power supply apparatus to the plurality of output terminals (41-44) based on the first comparison result signal or the second comparison result signal.

2. The voltage detector circuit (20) as claimed in claim 1,
wherein the current detector (R1-R4; 21-24) is configured to convert each of the plurality of detected output currents into a plurality of voltage values,
wherein the first comparator (31) is configured to compare a sum of the plurality of converted voltage values with a predetermined third threshold, and outputs the first comparison result signal when the sum of the plurality of voltage values is equal to or larger than the third threshold, and
wherein the second comparator (32) is configured to compare a maximum value of the plurality of converted voltage values with a predetermined fourth threshold, and outputs the second comparison result signal when the maximum value is larger than or equal to the fourth threshold.

3. The voltage detector circuit (20) as claimed in claim 2,
wherein the current detector (R1-R4; 21-24), after converting each of the plurality of detected output currents into a plurality of voltage values, is configured to amplify the voltage values.

4. The voltage detector circuit (20) as claimed in any one of claims 1 to 3,
wherein the first threshold is a rated current value of the entire terminal block (4), and
wherein the second threshold is a rated current value of each of the plurality of output terminals (41-44).

5. A power supply apparatus comprising the voltage detector circuit (20) as claimed in any one of claims 1 to 4,
wherein the power supply apparatus includes:
an inverter circuit (2) configured to convert DC power into AC power; and
a rectifier circuit (3) configured to convert AC power from the inverter circuit (2) into DC power, and
wherein the current stop circuit (Q11) stops operation of the inverter circuit (2).

6. The power supply apparatus as claimed in claim 5,
wherein the inverter circuit (2) includes:
a switching element (Q1) configured to switch the DC power and converts the DC power into AC power; and
a drive control circuit (10) configured to generate a drive control signal, and output the drive control signal to a switching element (Q1), and
wherein the current stop circuit (Q11) stops generation of the drive control signal in the drive control circuit (10).

7. The power supply apparatus as claimed in claim 6,
wherein the drive control signal is a PWM gate signal or an FM gate signal.

## Patentansprüche

1. Klemmenschutzspannungsdetektorkreis (20), umfassend:
einen Stromdetektor (R1-R4; 21-24), der dazu konfiguriert ist, eine Vielzahl von Ausgangsströmen nachzuweisen, die von einem Stromversorgungsgerät über eine Vielzahl von Ausgangsklemmen (41-44) zu einer Vielzahl von Lasten (61-64) fließt; und
einen ersten Komparator (31), der dazu konfiguriert ist, eine Summe der Vielzahl von nachgewiesenen Ausgangsströmen mit einem vorbestimmten ersten Schwellenwert zu vergleichen und ein erstes Vergleichsergebnissignal auszugeben, wenn die Summe der Vielzahl von Ausgangsströmen größer als der oder gleich dem ersten Schwellenwert ist;
**dadurch gekennzeichnet, dass** der Klemmenschutzspannungsdetektorkreis zum Schützen eines Klemmenblocks (4), der die Vielzahl von Ausgangsklemmen (41-44) in einem Stromversorgungsgerät aufweist, bereitgestellt ist,
wobei der Spannungsdetektorkreis (20) ferner Folgendes umfasst:
einen zweiten Komparator (32), der dazu konfiguriert ist, einen Maximalwert der Vielzahl von nachgewiesenen Ausgangsströmen mit einem vorbestimmten zweiten Schwellenwert zu vergleichen und ein zweites Vergleichsergebnissignal auszugeben, wenn der Maximalwert gleich oder größer als der zweite Schwellenwert ist; und
einen Stromstoppkreis (Q11), der dazu konfiguriert ist, basierend auf dem ersten Vergleichsergebnissignal oder dem zweiten Vergleichsergebnissignal das Fließen eines Stroms von dem Stromversorgungsgerät zu der Vielzahl von Ausgangsklemmen (41-44) zu stoppen.

2. Spannungsdetektorkreis (20) nach Anspruch 1,
wobei der Stromdetektor (R1-R4; 21-24) dazu konfiguriert ist, jeden der Vielzahl von nachgewiesenen Ausgangsströmen in eine Vielzahl von Spannungswerten umzuwandeln,
wobei der erste Komparator (31) dazu konfiguriert ist, eine Summe der Vielzahl von umgewandelten Spannungswerten mit einem vorbestimmten dritten Schwellenwert zu vergleichen, und das erste Vergleichsergebnissignal ausgibt, wenn die Summe der Vielzahl von Spannungswerten gleich dem oder größer als der dritte Schwellenwert ist, und
wobei der zweite Komparator (32) dazu konfiguriert ist, einen Maximalwert der Vielzahl von umgewandelten Spannungswerten mit einem vorbestimmten vierten Schwellenwert zu vergleichen, und das zweite Vergleichsergebnissignal ausgibt, wenn der Maximalwert größer als der oder gleich dem vierten Schwellenwert ist.

3. Spannungsdetektorkreis (20) nach Anspruch 2,
wobei der Stromdetektor (R1-R4; 21-24) nach dem Umwandeln jedes der Vielzahl von nachgewiesenen Ausgangsströmen in eine Vielzahl von Spannungswerten dazu konfiguriert ist, die Spannungswerte zu verstärken.

4. Spannungsdetektorkreis (20) nach einem der Ansprüche 1 bis 3,
wobei der erste Schwellenwert ein Nennstromwert des gesamten Klemmenblocks (4) ist, und
wobei der zweite Schwellenwert ein Nennstromwert jeder von der Vielzahl von Ausgangsklemmen (41-44) ist.

5. Stromversorgungsgerät, umfassend den Spannungsdetektorkreis (20) nach einem der Ansprüche 1 bis 4,
wobei das Stromversorgungsgerät Folgendes beinhaltet:
einen Wechselrichterkreis (2), der dazu konfiguriert ist, Gleichstrom in Wechselstrom umzuwandeln; und
einen Gleichrichterkreis (3), der dazu konfiguriert ist, Wechselstrom aus dem Wechselrichterkreis (2) in Gleichstrom umzuwandeln, und
wobei der Stromstoppskreis (Q11) den Betrieb des Wechselrichterkreises (2) stoppt.

6. Stromversorgungsgerät, nach Anspruch 5,
wobei der Wechselrichterkreis (2) Folgendes beinhaltet:
ein Schaltelement (Q1), das dazu konfiguriert ist, den Gleichstrom zu schalten, und den Gleichstrom in Wechselstrom umwandelt; und
einen Antriebssteuerkreis (10), der dazu konfiguriert ist, ein Antriebssteuersignal zu erzeugen, und das Antriebssteuersignal an ein Schaltelement (Q1) ausgibt, und
wobei der Stromstoppkreis (Q11) die Erzeugung des Antriebssteuersignals im Antriebssteuerkreis (10) stoppt.

7. Stromversorgungsgerät nach Anspruch 6, wobei das Antriebssteuersignal ein PWM-Gate-Signal oder ein FM-Gate-Signal ist.

## Revendications

1. Circuit détecteur de tension de protection de borne (20), comprenant :
un détecteur de courant (R1 à R4 ; 21 à 24) configuré pour détecter une pluralité de courants de sortie circulant d'un appareil d'alimentation électrique à une pluralité de charges (61 à 64) via une pluralité de bornes de sortie (41 à 44) ; et
un premier comparateur (31) configuré pour comparer une somme de la pluralité de courants de sortie détectés à un premier seuil prédéterminé, et délivrer en sortie un premier signal de résultat de comparaison lorsque la somme de la pluralité de courants de sortie est supérieure ou égale au premier seuil ;
**caractérisé en ce que** le circuit détecteur de tension de protection de borne est prévu pour protéger une plaque à bornes (4) ayant la pluralité de bornes de sortie (41 à 44) dans un appareil d'alimentation électrique,
dans lequel le circuit détecteur de tension (20) comprend en outre
un deuxième comparateur (32) configuré pour comparer une valeur maximale de la pluralité de courants de sortie détectés à un deuxième seuil prédéterminé, et délivrer en sortie un deuxième signal de résultat de comparaison lorsque la valeur maximale est supérieure ou égale au deuxième seuil ; et
un circuit de blocage de courant (Q11) configuré pour bloquer le passage d'un courant de l'appareil d'alimentation électrique à la pluralité de bornes de sortie (41 à 44) sur la base du premier signal de résultat de comparaison ou du deuxième signal de résultat de comparaison.

2. Circuit détecteur de tension (20) selon la revendication 1,
dans lequel le détecteur de courant (R1 à R4 ; 21 à 24) est configuré pour convertir chacun de la pluralité de courants de sortie détectés en une pluralité de valeurs de tension,
dans lequel le premier comparateur (31) est configuré pour comparer une somme de la pluralité de valeurs de tension converties à un troisième seuil prédéterminé, et délivre en sortie le premier signal de résultat de comparaison lorsque la somme de la pluralité de valeurs de tension est égale ou supérieure au troisième seuil, et
dans lequel le deuxième comparateur (32) est configuré pour comparer une valeur maximale de la pluralité de valeurs de tension converties à un quatrième seuil prédéterminé, et délivre en sortie le deuxième signal de résultat de comparaison lorsque la valeur maximale est supérieure ou égale au quatrième seuil.

3. Circuit détecteur de tension (20) selon la revendication 2,
dans lequel le détecteur de courant (R1 à R4 ; 21 à 24), après conversion de chacun de la pluralité de courants de sortie détectés en une pluralité de valeurs de tension, est configuré pour amplifier les valeurs de tension.

4. Circuit détecteur de tension (20) selon l'une quelconque des revendications 1 à 3,
dans lequel le premier seuil est une valeur de courant nominal de la totalité de la plaque à bornes (4), et
dans lequel le deuxième seuil est une valeur de courant nominal de chacune de la pluralité de bornes de sortie (41 à 44).

5. Appareil d'alimentation électrique comprenant le circuit détecteur de tension (20) selon l'une quelconque des revendications 1 à 4,
dans lequel l'appareil d'alimentation électrique comprend :
un circuit onduleur (2) conçu pour convertir la puissance CC en puissance CA ; et
un circuit redresseur (3) conçu pour convertir la puissance CA du circuit onduleur (2) en puissance CC, et
dans lequel le circuit de blocage de courant (Q11) arrête le fonctionnement du circuit onduleur (2).

6. Appareil d'alimentation électrique selon la revendication 5,
dans lequel le circuit onduleur (2) comprend :
un élément de commutation (Q1) conçu pour commuter la puissance CC et convertir la puissance CC en puissance CA ; et
un circuit de commande d'entraînement (10) configuré pour générer un signal de commande d'entraînement, et délivrer en sortie le signal de commande d'entraînement à un élément de commutation (Q1), et
dans lequel le circuit de blocage de courant (Q11) bloque la génération du signal de commande d'entraînement dans le circuit de commande d'entraînement (10).

7. Appareil d'alimentation électrique selon la revendication 6,
dans lequel le signal de commande d'entraînement est un signal de porte PWM ou un signal de porte FM.
